# EUROPEAN PATENT APPLICATION

(11) **EP 4 626 149 A1**
(43) Date of publication of application: **01.10.2025**
(21) Application number: 23893760.1
(22) Date of filing: 20.11.2023
(51) Int. Cl.: H05K 1/11, H05K 3/40

(54) **CIRCUIT BOARD ASSEMBLY, AND PREPARATION METHOD FOR CIRCUIT BOARD ASSEMBLY**

(30) Priority: 25.11.2022 CN 202211493981
(71) Applicant: Vivo Mobile Communication Co., Ltd., Dongguan, Guangdong 523863 (CN)
(72) Inventor: LI, Shijiao, Dongguan, Guangdong 523863 (CN); XU, Zhihua, Dongguan, Guangdong 523863 (CN)
(74) Representative: Conti, Marco
(86) International application number: PCT/CN2023/132506
(87) International publication number: WO 2024/109670

(57) **Abstract**

A circuit board assembly and a preparation method for a circuit board assembly are provided, and pertain to the field of chip technologies. The circuit board assembly includes a printed circuit board (101) and M pads, the M pads are provided at intervals on the printed circuit board (101), first vias (103) are provided on N pads (102) in the M pads, a second via (104) is further provided at a position between any two adjacent pads (102) in the N pads (102) on the printed circuit board (101), a center of the second via (104) deviates from a connection line between centers of the any two adjacent pads (102), both M and N are integers greater than 1, and N is less than or equal to M.

## Description

### CROSS-REFERENCE TO RELATED APPLICATIONS

This application claims priority to Chinese Patent Application No. 202211493981.9, filed in China on November 25, 2022, which is incorporated herein by reference in its entirety.

### TECHNICAL FIELD

This application pertains to the field of chip technologies, and specifically relates to a circuit board assembly and a preparation method for a circuit board assembly.

### BACKGROUND

With development of electronic technologies, consumers have increasingly high requirements on charging speeds of electronic devices such as mobile phones. Charging power of an electronic device increases from 18 W of common charging to 66 W or 80 W of fast charging and then to current 120 W or even 200 W. It can be learned that increasing the charging power is a key to improving a charging speed of the electronic device. When the charging power of the electronic device is increased, a current that needs to pass through a chip in a charging module increases accordingly from 2 A of common charging to 10 A of super charging or even a larger charging current.

When a printed circuit board (Printed Circuit Board, PCB) is designed, a hole is usually punched in a pad and routing is usually performed on a surface layer, to enhance an overcurrent capability. However, in a case that power is 120 W or even 200 W, a current can reach 10 A, and an overcurrent capability requirement for a large current during high-power charging is difficult to meet by punching the hole in the pad and performing routing on the surface layer. Therefore, a solution for providing vias between pads is proposed.

However, in the related technology, the solution for providing vias between pads improves an overcurrent capability for a large current during high-power charging, but an actually manufactured PCB has obvious deficiency in soldering reliability. For example, peripheries of the pads are occupied by traces and vias, resulting in a case such as a short circuit caused by pseudo soldering or solder bridging between the pads. It can be learned that reliability of a circuit board assembly is poor after an overcurrent capability for a current is improved.

### SUMMARY

An objective of embodiments of this application is to provide a circuit board assembly and a preparation method for a circuit board assembly, to resolve a problem that reliability of a circuit board assembly is poor after an overcurrent capability for a current is improved.

According to a first aspect, an embodiment of this application provides a circuit board assembly, including a printed circuit board and M pads, where the M pads are provided at intervals on the printed circuit board, first vias are provided on N pads in the M pads, a second via is further provided at a position between any two adjacent pads in the N pads on the printed circuit board, a center of the second via deviates from a connection line between centers of the any two adjacent pads, both M and N are integers greater than 1, and N is less than or equal to M.

According to a second aspect, an embodiment of this application further provides a preparation method for a circuit board assembly, where the method includes:
obtaining a first to-be-prepared printed circuit board, where M pads are provided at intervals on the first to-be-prepared printed circuit board, and first vias are provided on N pads in the M pads; and
punching a second via at a position between any two adjacent pads in the N pads on the first to-be-prepared printed circuit board, to obtain a printed circuit board, where a center of the second via deviates from a connection line between centers of the any two adjacent pads, where
both M and N are integers greater than 1, and N is less than or equal to M.

In embodiments of this application, the M pads are provided at intervals on the printed circuit board, the first vias are provided on the N pads in the M pads, and the second via is provided at the position between the any two adjacent pads in the N pads, to improve an overcurrent capability for a current. In addition, the center of the second via deviates from the connection line between the centers of the any two adjacent pads. In this way, a distance between the second via and the pad is increased, thereby reducing occupation of the pad by the second via, improving integrity of the pad, and then improving reliability of the circuit board assembly.

### BRIEF DESCRIPTION OF DRAWINGS

FIG. 1 is a diagram 1 of a structure of a circuit board assembly according to an embodiment of this application;

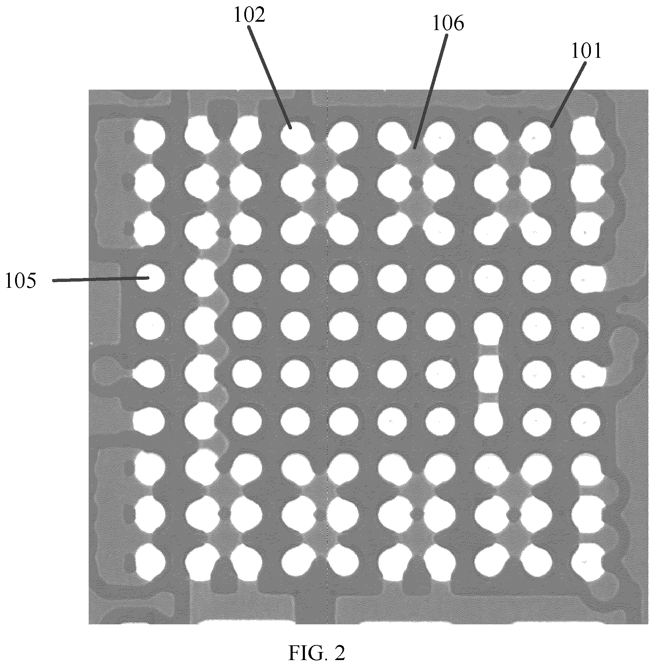

FIG. 2 is a diagram 1 of a physical product of a circuit board assembly according to an embodiment of this application;
FIG. 3 is a diagram 2 of a physical product of a circuit board assembly according to an embodiment of this application;
FIG. 4 is a diagram of a connection relationship between a circuit board assembly and a chip according to an embodiment of this application;
FIG. 5 is a diagram 2 of a structure of a circuit board assembly according to an embodiment of this application;
FIG. 6 is a diagram 3 of a structure of a circuit board assembly according to an embodiment of this application;
FIG. 7 is a diagram 4 of a structure of a circuit board assembly according to an embodiment of this application; and
FIG. 8 is a flowchart of a preparation method for a circuit board assembly according to an embodiment of this application.

### DESCRIPTION OF EMBODIMENTS

The following clearly describes the technical solutions in embodiments of this application with reference to the accompanying drawings in embodiments of this application. It is clear that the described embodiments are some rather than all of embodiments of this application. Based on embodiments of this application, all other embodiments obtained by a person of ordinary skill in the art fall within the protection scope of this application.

The terms "first", "second", and the like in the specification and claims of this application are used to distinguish between similar objects, but are not used to describe a specific sequence or order. It should be understood that data used in this way may be interchangeable in an appropriate case, so that embodiments of this application can be implemented in a sequence other than those shown or described herein, objects distinguished by "first", "second", and the like are generally of one type, and a quantity of objects is not limited. For example, there may be one or more first objects. In addition, in the specification and claims, "and/or" represents at least one of connected objects, and the character "/" generally represents an "or" relationship between associated objects.

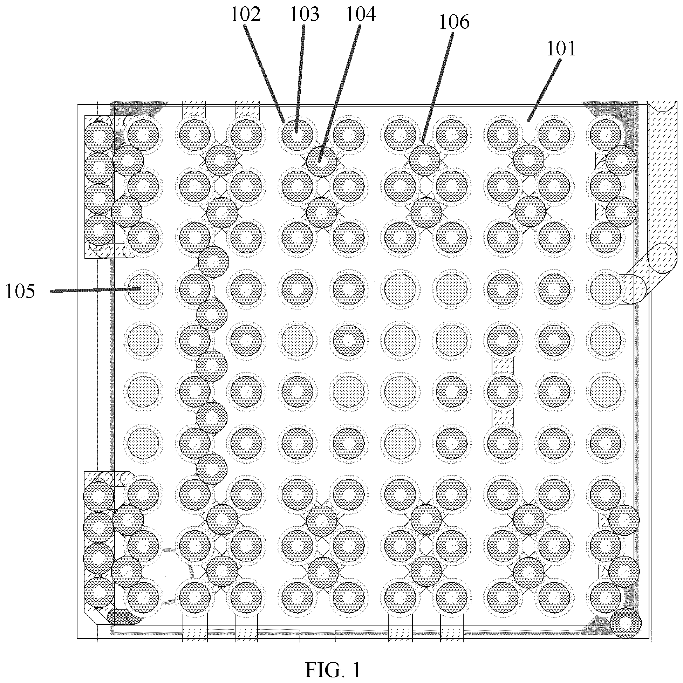

Refer to FIG. 1. FIG. 1 is a diagram 1 of a structure of a circuit board assembly according to an embodiment of this application. As shown in FIG. 1, the circuit board assembly includes a printed circuit board 101 and M pads, the M pads are provided at intervals on the printed circuit board 101, first vias 103 are provided on N pads 102 in the M pads, a second via 104 is further provided at a position between any two adjacent pads 102 in the N pads 102 on the printed circuit board 101, a center of the second via 104 deviates from a connection line between centers of the any two adjacent pads 102, both M and N are integers greater than 1, and N is less than or equal to M.

The M pads on the printed circuit board 101 further include an independent pad 105, that is, no first via 103 is provided on the pad 105.

The M pads may be provided in an array on the printed circuit board 101, to improve uniformity of spacings between the pads, and facilitate providing of the second via 104 between the pads subsequently.

Sizes of the first via 103 and the second via 104 may be the same, and copper foils may be provided on the first via 103 and the second via 104, to enhance conductivity.

In this embodiment of this application, the M pads are provided at intervals on the printed circuit board 101, the first vias 103 are provided on the N pads 102 in the M pads, and the second via 104 is provided at the position between the any two adjacent pads 102 in the N pads 102, to improve an overcurrent capability for a current. In addition, the center of the second via 104 deviates from the connection line between the centers of the any two adjacent pads 102. In this way, a distance between the second via 104 and the pad 102 is increased compared with that in a manner in which a second via is provided on a connection line between centers of any two adjacent pads, thereby reducing occupation of the pad 102 by the second via 104, improving integrity of the pad 102, and then improving reliability of the circuit board assembly.

Optionally, all the M pads on the printed circuit board 101 may be non-solder mask defined pads (Non-Solder Mask Defined Pad, NSMD).

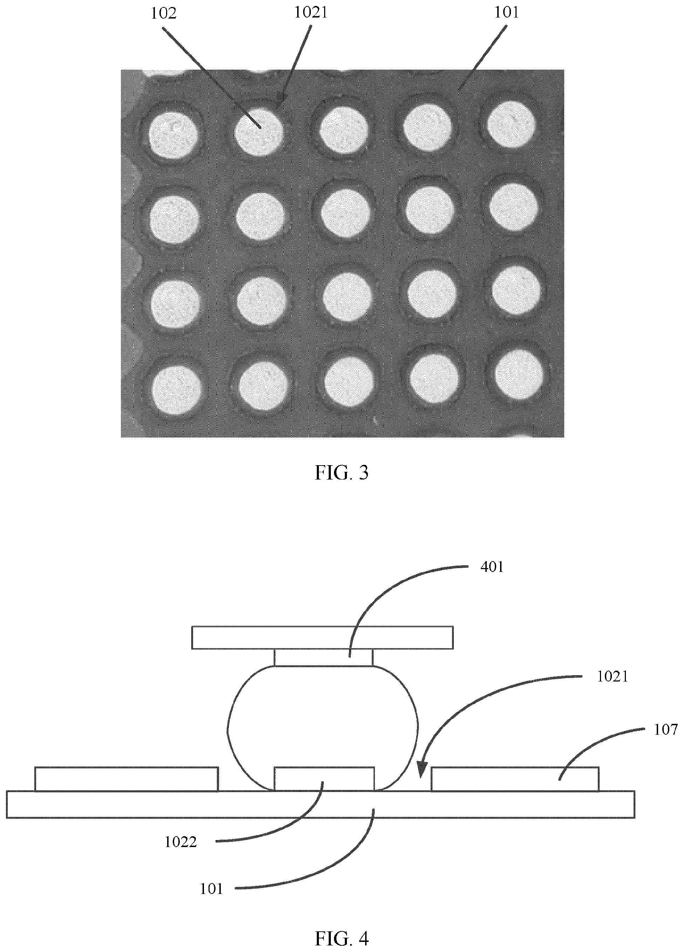

As shown in FIG. 3 and FIG. 4, each pad (including the pad 102 and the pad 105) in the M pads includes a pad body 1022 and a solder mask groove 1021, the solder mask groove 1021 surrounds the pad body 1022, and the solder mask groove 1021 is located between the pad body 1022 and the second via 104, that is, a loop of solder mask groove 1021 is provided around the pad body 1022. The solder mask groove 1021 may include a gap between ink 107 and the pad body 1022. The pad body 1022 and the surrounding ink 107 may be separated by the solder mask groove 1021 for a specific distance. When the pad body 1022 is soldered with a material end (for example, a pad 401 on a chip), excess solder paste may flow into the solder mask groove 1021, to reduce occurrence of solder bridging between adjacent pads.

The ink 107 may be a barrier layer that is provided on the printed circuit board and that has acid corrosion resistance and alkali corrosion resistance. The ink 107 can prevent circuit corrosion, and protect a circuit in an etching process.

The second via 104 provided on the printed circuit board 101 is located between the any two adjacent pads 102 in the N pads 102, and is likely to occupy the adjacent pads 102. Occupation of the solder mask groove 1021 is especially significant. Due to occupation by the second via 104, the solder mask groove 1021 is only partially retained. When excess solder paste cannot flow into the solder mask groove 1021, the solder paste is prone to stacking, resulting in a short circuit caused by solder bridging between different pads, thereby causing a function failure of a terminal device.

In an example, the second via 104 is provided between the any two adjacent pads 102 in the N pads 102, and the center of the second via 104 deviates from the connection line between the centers of the any two adjacent pads 102, to increase a distance between the second via 104 and the solder mask groove 1021, reduce occupation of the solder mask groove 1021 by the second via 104, and improve integrity of the pad 102 and the solder mask groove 1021. In this way, a form of a solder joint is improved, and problems of pseudo soldering and solder bridging during soldering are resolved, thereby improving soldering reliability of the PCB.

Optionally, the first via 103 is electrically connected to the second via 104 through a trace 106.

In an example, the first vias 103 are provided on the N pads 102 in the M pads, the second via 104 is provided at the position between the any two adjacent pads 102 in the N pads 102, and the trace 106 is provided between the first via 103 and the second via 104, so that signal transmission can be performed between the adjacent pads 102 through the trace 106. The center of the second via 104 deviates from the connection line between the centers of the any two adjacent pads 102, so that the second via 104 is staggered between the any two adjacent pads 102. A trace 106 led from a first via 103 on each of the two adjacent pads 102 may extend toward the position of the second via 104 for electrical connection to the second via 104, to reduce a redundant trace between the pads 102, and avoid a case that the trace 106 and the second via 104 occupy the pad 102 in different directions when the trace 106 and the second via 104 are respectively located in the different directions of the pad 102, thereby improving integrity of the pad 102 and the solder mask groove 1021. The circuit board assembly has high reliability while an overcurrent capability for a current is improved.

Optionally, the second via 104 is connected to one of the any two adjacent pads 102 in the N pads 102 through a first trace, the second via 104 is connected to the other of the any two adjacent pads 102 in the N pads 102 through a second trace, and an included angle between the first trace and the second trace is greater than or equal to 90 degrees.

In an example, the second via 104 is provided between the any two adjacent pads 102 in the N pads 102, the center of the second via 104 deviates from the connection line between the centers of the any two adjacent pads 102, and the trace 106 includes the first trace and the second trace. In this way, one of the any two adjacent pads 102 in the N pads 102 may be electrically connected to the second via 104 through extension of the first trace, and the other of the any two adjacent pads 102 in the N pads 102 may be electrically connected to the second via 104 through extension of the second trace, and the included angle between the first trace and the second trace is greater than or equal to 90 degrees, so that a case that the trace 106 and the second via 104 occupy the pad 102 in different directions is reduced, thereby improving integrity of the pad 102 and the solder mask groove 1021. The circuit board assembly has high reliability while an overcurrent capability for a current is improved.

Optionally, the second via 104 is provided in a central region of any L adjacently provided pads 102 in the N pads 102. L is an integer greater than 1 and less than or equal to N.

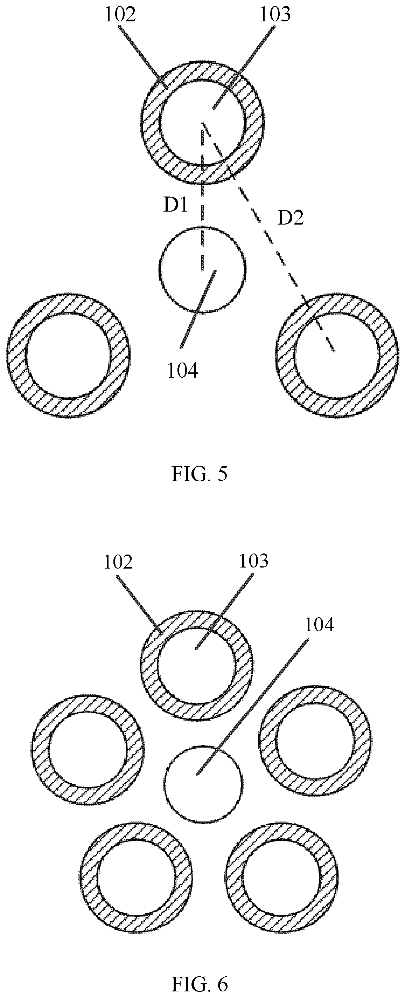

In an example, as shown in FIG. 5, the second via 104 may be provided in a central region of any three adjacently provided pads 102 in the N pads 102, the three pads 102 may be distributed in a form of a triangle, and the second via 104 may be located in a central region of the triangle. In other words, the center of the second via 104 deviates from a connection line between centers of any two adjacent pads 102 in the three pads 102, so that occupation of any one of the three pads 102 by the second via 104 is reduced. In addition, a trace 106 led from a first via 103 on each of the three pads 102 may extend toward the position of the second via 104 for electrical connection to the second via 104, so that a case that the trace 106 and the second via 104 occupy the pad 102 in different directions is reduced, thereby improving regularity of the pad 102, improving a form of a solder joint, and reducing a case that a stress resistance capability of the circuit board assembly is poor because an area of the pad 102 on the PCB is large, a size of a solder ball at a material end is small, and the solder joint is in an inverted funnel shape. In addition, integrity of the solder mask groove 1021 is improved, and stacking that occurs when excess solder paste cannot flow into the solder mask groove 1021 is reduced, so that reliability of the circuit board assembly is improved.

The three pads 102 may be distributed in a form of a regular triangle, and the second via 104 may be located at a position of a center point of the regular triangle, so that the center of the second via 104 has a same first distance D1 to a center of each of the three pads 102. In this way, in a case that the second via 104 interferes with the pad 102 and/or the second via 104 interferes with the solder mask groove 1021, effect of the same second via 104 on all of the three pads 102 can be dispersed. In addition, a trace 106 led from a first via 103 on each of the three pads 102 may extend toward the position of the second via 104 for electrical connection to the second via 104, to reduce a redundant trace between the three pads 102. Because each of the three pads 102 has the same first distance D1 to the second via 104, the trace 106 between each pad 102 and the second via 104 has a uniform length, so that regularity of the pad 102 and integrity of the solder mask groove 1021 are further improved. The circuit board assembly has high reliability while an overcurrent capability for a current is improved.

In another example, the second via 104 may be provided in a central region of any four adjacently provided pads 102 in the N pads 102, the four pads 102 may be distributed in a form of a rectangle, and the second via 104 may be located in a central region of the rectangle. In other words, the center of the second via 104 deviates from a connection line between centers of any two adjacent pads 102 in the four pads 102, so that occupation of any one of the four pads 102 by the second via 104 is reduced. In addition, a trace 106 led from a first via 103 on each of the four pads 102 may extend toward the position of the second via 104 for electrical connection to the second via 104, and pads 102 at diagonal positions may also be connected by sharing a same trace 106, thereby reducing a redundant trace between the four pads 102, and reducing a case that the trace 106 and the second via 104 occupy the pad 102 in different directions. In this way, regularity of the pad 102 is improved, integrity of the solder mask groove 1021 is improved, and stacking that occurs when excess solder paste cannot flow into the solder mask groove 1021 is reduced, so that reliability of the circuit board assembly is improved.

The four pads 102 may be distributed in a form of a square, and the second via 104 may be located at a position of an intersection point of diagonals of the square, so that the center of the second via 104 has a same first distance D1 to a center of each of the four pads 102. In this way, in a case that the second via 104 interferes with the pad 102 and/or the second via 104 interferes with the solder mask groove 1021, effect of the same second via 104 on all of the four pads 102 can be dispersed. In addition, the trace 106 between each pad 102 and the second via 104 has a uniform length, so that regularity of the pad 102 and integrity of the solder mask groove 1021 are further improved. The circuit board assembly has high reliability while an overcurrent capability for a current is improved.

In another example, as shown in FIG. 6, the second via 104 may be provided in a central region of any five adjacently provided pads 102 in the N pads 102, the five pads 102 may be distributed in a form of a pentagon, and the second via 104 may be located in a central region of the pentagon. In other words, the center of the second via 104 deviates from a connection line between centers of any two adjacent pads 102 in the five pads 102, so that occupation of any one of the five pads 102 by the second via 104 is reduced. In addition, a trace 106 led from a first via 103 on each of the five pads 102 may extend toward the position of the second via 104 for electrical connection to the second via 104, thereby reducing a redundant trace between the five pads 102, and reducing a case that the trace 106 and the second via 104 occupy the pad 102 in different directions. In this way, regularity of the pad 102 is improved, integrity of the solder mask groove 1021 is improved, and stacking that occurs when excess solder paste cannot flow into the solder mask groove 1021 is reduced, so that reliability of the circuit board assembly is improved.

The five pads 102 may be distributed in a form of a regular pentagon, and the second via 104 may be located at a position of a center point of the regular pentagon, so that the center of the second via 104 has a same first distance D1 to a center of each of the five pads 102. In this way, in a case that the second via 104 interferes with the pad 102 and/or the second via 104 interferes with the solder mask groove 1021, effect of the same second via 104 on all of the five pads 102 can be dispersed. In addition, the trace 106 between each pad 102 and the second via 104 has a uniform length, so that regularity of the pad 102 and integrity of the solder mask groove 1021 are further improved. The circuit board assembly has high reliability while an overcurrent capability for a current is improved.

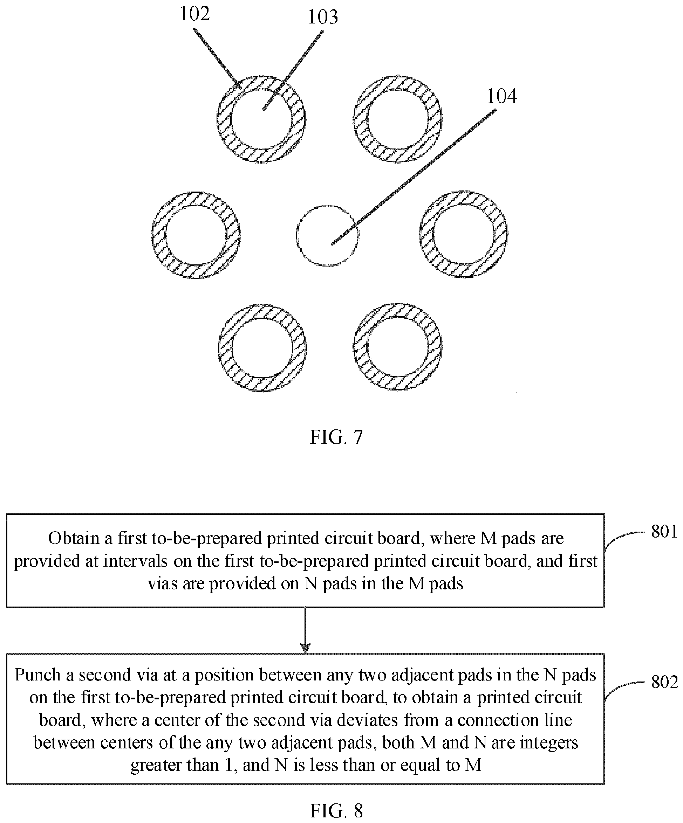

In another example, as shown in FIG. 7, the second via 104 may be provided in a central region of any six adjacently provided pads 102 in the N pads 102, the six pads 102 may be distributed in a form of a hexagon, and the second via 104 may be located in a central region of the hexagon. In other words, the center of the second via 104 deviates from a connection line between centers of any two adjacent pads 102 in the six pads 102, so that occupation of any one of the six pads 102 by the second via 104 is reduced. In addition, a trace 106 led from a first via 103 on each of the six pads 102 may extend toward the position of the second via 104 for electrical connection to the second via 104, and pads 102 at diagonal positions may also be connected by sharing a same trace 106, thereby reducing a redundant trace between the six pads 102, and reducing a case that the trace 106 and the second via 104 occupy the pad 102 in different directions. In this way, regularity of the pad 102 is improved, integrity of the solder mask groove 1021 is improved, and stacking that occurs when excess solder paste cannot flow into the solder mask groove 1021 is reduced, so that reliability of the circuit board assembly is improved.

The six pads 102 may be distributed in a form of a regular hexagon, and the second via 104 may be located at a position of an intersection point of diagonals of the regular hexagon, so that the center of the second via 104 has a same first distance D1 to a center of each of the six pads 102. In this way, in a case that the second via 104 interferes with the pad 102 and/or the second via 104 interferes with the solder mask groove 1021, effect of the same second via 104 on all of the six pads 102 can be dispersed. In addition, the trace 106 between each pad 102 and the second via 104 has a uniform length, so that regularity of the pad 102 and integrity of the solder mask groove 1021 are further improved. The circuit board assembly has high reliability while an overcurrent capability for a current is improved.

It should be noted that the second via 104 is provided in the central region of the any L adjacently provided pads 102 in the N pads 102, and L may alternatively be another quantity, for example, 8, 9, or 12, and may be adjusted according to an actual situation. Same technical effects can be achieved, and details are not described herein again.

There is the first distance D1 between the center of the second via 104 and a center of each of the L pads 102, there is a second distance D2 between centers of any two adjacent pads 102 in the L pads 102, and a ratio of the first distance D1 to the second distance D2 is greater than 1:2, to increase a distance between the second via 104 and the pad 102, reduce occupation of the pad 102 and/or the solder mask groove 1021 by the second via 104, and improve integrity of the pad 102 and the solder mask groove 1021. In this way, a form of a solder joint is improved, and problems of pseudo soldering and solder bridging during soldering are resolved, thereby improving reliability of the circuit board assembly.

Optionally, a size of the trace 106 is less than or equal to a size of the pad 102, and/or the size of the trace 106 is less than or equal to a size of the second via 104.

In embodiments of this application, a width of the trace 106 between the pads 102 in the M pads is reduced, so that the size of the trace 106 is less than or equal to the size of the pad 102, and/or the size of the trace 106 is less than or equal to the size of the second via 104, thereby reducing a case that large-area interference between the trace 106 and the pad 102 leads to poor integrity of the solder mask groove 1021. In this way, routing on a surface layer of the PCB is implemented and the via is added, so that an overcurrent capability is improved. In addition, a size and integrity of the solder mask groove 1021 are retained to a maximum extent, so that problems such as solder bridging and pseudo soldering generated during soldering are resolved.

Optionally, a quantity of second vias 104 adjacent to each of the N pads 102 is less than or equal to two.

In embodiments of this application, the N pads 102 may include a plurality of pad networks, and one pad network may include at least two pads 102. A second via 104 may be provided between any two adjacent pads 102 in the at least two pads 102, so that a center of the second via 104 deviates from a connection line between centers of the any two adjacent pads 102. In addition, a trace 106 led from each of the two adjacent pads 102 extends toward a position of the second via 104 for electrical connection to the second via 104, a width of the trace 106 may be less than or equal to a width of the pad 102, and a quantity of second vias 104 electrically connected to each pad 102 is less than or equal to two. In this way, routing on a surface layer of the PCB is implemented and the via is added, so that an overcurrent capability is improved. In addition, a size and integrity of the solder mask groove 1021 are retained to a maximum extent, so that problems such as solder bridging and pseudo soldering generated during soldering are resolved, and reliability of the circuit board assembly is improved.

When the PCB is designed, one or more pads 102 may be connected to an independent pad 105 through a trace 106 according to an actual requirement, and a second via 104 may be provided on the trace 106 between the pad 102 and the independent pad 105, so that a trace led from the independent pad 105 faces the second via 104, and a trace led from the pad 102 faces the second via 104, thereby reducing a redundant trace between the pad 102 and the independent pad 105, and reducing occupation of the pad by the trace 106 and the second via 104. In this way, integrity of the pad is improved. The circuit board assembly has high reliability while an overcurrent capability for a current is improved.

Refer to FIG. 8. FIG. 8 is a flowchart of a preparation method for a circuit board assembly according to an embodiment of this application. The method is used to prepare the foregoing circuit board assembly. The method includes the following steps.

Step 801: Obtain a first to-be-prepared printed circuit board, where M pads are provided at intervals on the first to-be-prepared printed circuit board, and first vias are provided on N pads in the M pads.

In this step, the first to-be-prepared printed circuit board may be a to-be-processed PCB that has not been provided with a second via. The M pads are provided on the first to-be-prepared printed circuit board, the M pads may be provided in an array on the first to-be-prepared printed circuit board, and the first vias are provided on the N pads in the M pads, to facilitate subsequent soldering with a material end by using the pads.

Step 802: Punch a second via at a position between any two adjacent pads in the N pads on the first to-be-prepared printed circuit board, to obtain a printed circuit board, where a center of the second via deviates from a connection line between centers of the any two adjacent pads.

Both M and N are integers greater than 1, and N is less than or equal to M.

In this step, an overcurrent capability of the circuit board assembly may be improved by providing the via, the second via is located between the any two adjacent pads, and the center of the second via deviates from the connection line between the centers of the any two adjacent pads, to reduce occupation of the pad by the second via, and improve a form of a solder joint.

In this embodiment of this application, in a PCB design process, the M pads are provided on the first to-be-prepared printed circuit board, the first vias are provided on the N pads in the M pads, and the second via is punched at the position between the any two adjacent pads in the N pads on the first to-be-prepared printed circuit board, to improve an overcurrent capability for a current. In addition, the center of the second via deviates from the connection line between the centers of the any two adjacent pads, to obtain the printed circuit board. In the printed circuit board, a distance between the second via and the pad is increased, thereby reducing occupation of the pad by the second via, improving integrity of the pad, and then improving reliability of the circuit board assembly.

The punching a second via at a position between any two adjacent pads in the N pads on the first to-be-prepared printed circuit board, to obtain a printed circuit board, where a center of the second via deviates from a connection line between centers of the any two adjacent pads includes:
punching the second via at the position between the any two adjacent pads in the N pads on the first to-be-prepared printed circuit board, to obtain a second to-be-prepared printed circuit board, where the center of the second via deviates from the connection line between the centers of the any two adjacent pads; and
performing line connection on the second to-be-prepared printed circuit board, to obtain the printed circuit board, where a trace between any two adjacent pads on the printed circuit board extends toward the position of the second via for electrical connection to the second via.

In this way, a trace may be provided between two adjacent pads, and a trace led from each of the two adjacent pads extends toward the position of the second via for electrical connection to the via, to reduce a redundant trace between the pads, and avoid a case that the trace and the via occupy the pad in different directions when the trace and the via are respectively located in the different directions of the pad, thereby improving integrity of the pad. The circuit board assembly has high reliability while an overcurrent capability for a current is improved.

Optionally, the punching a second via at a position between any two adjacent pads in the N pads on the first to-be-prepared printed circuit board, to obtain a printed circuit board, where a center of the second via deviates from a connection line between centers of the any two adjacent pads includes:
in a case that a target region on the first to-be-prepared printed circuit board meets a via punching condition, punching the second via in the target region, to obtain the printed circuit board.

The target region is the position between the any two adjacent pads in the N pads, and the target region deviates from the connection line between the centers of the any two adjacent pads.

In this embodiment of this application, when the second via is punched in the target region on the first to-be-prepared printed circuit board, interference of the second via to adjacent pads in the N pads is considered. In a case that the interference of the second via to the pads is less than a target threshold, that is, a spacing between any two adjacent pads in the N pads is large, the second via may be provided between the two pads. On the contrary, no via is punched. In this way, integrity of the pad is improved.

It should be noted that, in this specification, the term "include", "have", or any other variant thereof is intended to cover non-exclusive inclusion, so that a process, method, article, or apparatus that includes a series of elements includes not only those elements but also other elements that are not explicitly listed, or includes elements inherent to such a process, method, article, or apparatus. In a case without more restrictions, for an element limited by the statement "include a...", a process, method, article, or apparatus that includes the element may further include another same element. In addition, it should be noted that the scope of the method and apparatus in embodiments of this application is not limited to performing a function in an order shown or discussed, and may further include performing a function in a basically simultaneous manner or in a reverse order according to a related function. For example, the described method may be performed in a different order, and various steps may be added, omitted, or combined. In addition, features described with reference to some examples may be combined in other examples.

Embodiments of this application are described above with reference to the accompanying drawings. However, this application is not limited to the foregoing specific implementations. The foregoing specific implementations are merely an example but not a limitation. Many forms that can be made by a person of ordinary skill in the art without departing from the principle of this application and the protection scope of the claims fall within the protection scope of this application.

## Claims

1. A circuit board assembly, comprising a printed circuit board and M pads, wherein the M pads are provided at intervals on the printed circuit board, first vias are provided on N pads in the M pads, a second via is further provided at a position between any two adjacent pads in the N pads on the printed circuit board, a center of the second via deviates from a connection line between centers of the any two adjacent pads, both M and N are integers greater than 1, and N is less than or equal to M.

2. The circuit board assembly according to claim 1, wherein the second via is provided in a central region of any L adjacently provided pads in the N pads, and L is an integer greater than 1 and less than or equal to N.

3. The circuit board assembly according to claim 2, wherein there is a first distance between the center of the second via and a center of each of the L pads, there is a second distance between centers of any two adj acent pads in the L pads, and a ratio of the first distance to the second distance is greater than 1:2.

4. The circuit board assembly according to any one of claims 1 to 3, wherein the first via and the second via are electrically connected through a trace.

5. The circuit board assembly according to claim 4, wherein a size of the trace is less than or equal to a size of the pad, and/or the size of the trace is less than or equal to a size of the second via.

6. The circuit board assembly according to any one of claims 1 to 3, wherein the second via is connected to one of the any two adjacent pads in the N pads through a first trace, the second via is connected to the other of the any two adjacent pads in the N pads through a second trace, and an included angle between the first trace and the second trace is greater than or equal to 90 degrees.

7. The circuit board assembly according to any one of claims 1 to 3, wherein each of the M pads is a non-solder mask defined pad.

8. The circuit board assembly according to claim 7, wherein each of the M pads comprises a pad body and a solder mask groove, the solder mask groove surrounds the pad body, and the solder mask groove is located between the pad body and the second via.

9. The circuit board assembly according to claim 8, wherein ink is further provided on the printed circuit board, and a gap between the ink and the pad body forms the solder mask groove.

10. A preparation method for a circuit board assembly, wherein the method comprises:
obtaining a first to-be-prepared printed circuit board, wherein M pads are provided at intervals on the first to-be-prepared printed circuit board, and first vias are provided on N pads in the M pads; and
punching a second via at a position between any two adjacent pads in the N pads on the first to-be-prepared printed circuit board, to obtain a printed circuit board, wherein a center of the second via deviates from a connection line between centers of the any two adjacent pads, wherein
both M and N are integers greater than 1, and N is less than or equal to M.
